# EUROPÄISCHE PATENTSCHRIFT

(11) **EP 2 255 604 B1**
(45) Veröffentlichungstag und Bekanntmachung des Hinweises auf die Patenterteilung: **26.04.2017**
(21) Anmeldenummer: 09720476.2
(22) Anmeldetag: 25.02.2009
(51) Int. Cl.: H05K 7/20

(54) **STEUERGERÄT**
CONTROL UNIT
APPAREIL DE COMMANDE

(30) Priorität: 12.03.2008 DE 102008000621
(43) Veröffentlichungstag der Anmeldung: 01.12.2010
(73) Patentinhaber: Robert Bosch GmbH, 70442 Stuttgart (DE)
(72) Erfinder: VOIGTLAENDER, Klaus, 73117 Wangen (DE); KIMMICH, Peter, 71101 Schoenaich (DE)
(86) Internationale Anmeldenummer: PCT/EP2009/052182
(87) Internationale Veröffentlichungsnummer: WO 2009/112363

(56) Entgegenhaltungen:
- DE-A1-102005 062 590
- JP-A- 2004 274 959
- JP-A- 2005 057 928
- US-A1- 2004 004 356
- US-A1- 2006 023 426

## Beschreibung

### Stand der Technik

Viele Steuergeräte in Kraftfahrzeugen bestehen aus mindestens 3 Bauteilen, und zwar aus einem Boden, einem Schaltungsträger und einem Deckel. Hier ist es wichtig, dass ein guter thermischer Kontakt zwischen dem Schaltungsträger und der Leistungselektronik bzw. zwischen den beiden Gehäuseteilen sichergestellt wird. Während des Betriebs heizen sich der Schaltungsträger und die Leistungselektronik auf. Die Wärmeableitung erfolgt bisher beispielsweise mit Hilfe von an den beiden Gehäuseteilen vorgesehenen Kühlrippen. Hierdurch kann die entstehende Verlustwärme abgeführt werden.

Bei diesem Verfahren ist es ein Nachteil, dass mit engen Toleranzen gearbeitet werden muss, damit eine zuverlässige Wärmeabfuhr sichergestellt wird. Das Einhalten sehr enger Toleranzen verteuert aber die Herstellung derartiger Schaltungsträger. Die Wärmeableitung kann auch mit Hilfe von Wasserkühlung, des Pelletiereffekts, von Wärmetauschern oder Lüftern erfolgen. Die Implementierung derartiger Einrichtungen ist aber insbesondere im Kraftfahrzeugbau sehr schwierig und aufwändig.

Bekannt ist es, die Wärme durch den Schaltungsträger in den Kühlkörper zu leiten. Mit Hilfe von Pasten, Klebern oder Feststoffen, die zwischen den Bauteilen eingesetzt werden, kann der Wärmetransport direkt zum Kühler erfolgen. Ebenfalls ist die Kapillarwirkung von dünnen Röhren bekannt, die Wasser entgegen der Schwerkraft nach oben bewegen, sodass dieser Effekt genutzt werden kann, um die Wärme abzuleiten.

In Steuergeräten, insbesondere für größere Leistungsklassen, treten erhebliche Wärmemengen auf, die über Kühlpfade abgebaut werden müssen. Dazu werden oft Kühl

rippen am Gehäuse angebracht und wärmeleitende Pasten oder Feststoffe zusätzlich verbaut. Dies erzeugt erhöhte Kosten.

Die Offenlegungsschrift US 2006/023426 A1 beschreibt ein Motorsteuergerät, welches in einem Gehäuse eines Automatikgetriebes angeordnet ist. Das Gehäuse ist aus einem Material aufgebaut, welches nur eine geringe Wärmeleitung aufweist und ein Substrat flüssigkeitsdicht einschließt. Ein Kühlkörper ist auf dem Substrat angeordnet, um Wärme einer elektronischen Schaltung auf dem Substrat abzuführen. Der Kühlkörper steht in Kontakt mit einer Innenwand des Gehäuses, so dass Wärme über den Kühlkörper an das Gehäuse abgegeben werden kann Das Substrat ist ein Keramikmaterial mit guten wärmeableitenden Eigenschaften, welches mit einem wärmeleitenden Kleber mit dem Kühlkörper verbunden ist. Der Kühlkörper weist Vorsprünge auf, die den Kühlkörper gegenüber dem Gehäuse abstützen, wobei zwischen zwei Vorsprüngen ein Raum gebildet wird, durch den aufgrund von Konvektion innerhalb des Gehäuses ein Gas strömt.

Aus der Offenlegungsschrift DE 10 2005 062 590 A1 ist eine Schaltungsanordnung mit einer Wärmetransfereinrichtung bekannt. Die Schaltungsanordnung umfasst mindestens einen von einem Wärmetransportmedium durchströmten Wärmetransportkanal, mit dem ein elektronisches Bauelement gekühlt werden kann. Zusätzlich ist vorgesehen, dass die Schaltungsanordnung mindestens eine zum Wärmetransfer innerhalb der Schaltungsanordnung ausgebildete Heatpipe aufweist, die mit dem Wärmetransportkanal thermisch verbunden ist. An einem Bauteil entstehende Wärme wird zunächst in eine Wärmebank übertragen, die als Wärmereservoir dient und die Wärme in die unmittelbare Umgebung einer Heatpipe leitet. Über die Heatpipe wird die Wärme in Richtung eines Transportkanals für das Wärmetransportmedium geführt und anschließend durch das Wärmetransportmedium abgeführt.

### Offenbarung der Erfindung

Erfindungsgemäß wird das Steuergerät nach Anspruch 1 vorgeschlagen. Vorteilhaft ist es, dass die Kühlpfade als Vertiefungen und/oder Gräben ausgebildet sind. Durch kurze Wege mit Hilfe dieser Kühlpfade, die in das Steuergerät integriert werden, wird eine verbesserte Kühlwirkung erzielt. Die Kühlpfade lassen sich auf einfache Weise in vorhandene auch sehr kleine Gehäuse einbauen. Es tritt hierdurch nur eine geringe Temperaturbelastung auf. Außerdem können derart ausgestaltete Steuergeräte auch großen Temperaturschwankungen ausgesetzt werden. Da nur ein kleiner Bauraum benötigt wird, kann Gewicht eingespart und somit können Baukosten gesenkt werden.

Außerdem ist es vorteilhaft, dass die Kühlpfade als flache Vertiefungen ausgebildet sind. Die Kühlpfade können in vorhandene Gehäuse eingebaut werden. Derartige Gehäuse können größere Temperaturschwankungen ohne Schaden überstehen.

Vorteilhaft ist es auch, dass die breiten Kühlpfade in etwa doppelt so breit sind wie die schmalen Kühlpfade.

Ferner ist es von Vorteil, dass die Tiefe der breiten Gräben bzw. Kühlpfade etwa halb bis doppelt so groß ist wie die der schmalen Gräben bzw. Kühlpfade.

Vorteilhaft ist es auch, dass die Kühlpfade im Boden und/oder im Schaltungsträger und/oder im Deckel vorgesehen sind und eine Tiefe kleiner als 200 µm oder kleiner als 120 µm oder zwischen 10 µm und 120 µm insbesondere zwischen 50 µm und 110 µm aufweisen.

In weiterer Ausgestaltung der Erfindung ist es vorteilhaft, dass die schmalen Kühlpfade eine Größe zwischen 5 µm und 200 µm oder zwischen 10 µm und 150 µm oder zwischen 80 µm und 120 µm aufweisen.

Vorteilhaft ist auch, dass die breiten Kühlpfade eine Größe zwischen 100 µm und 10 mm oder eine Größe zwischen 200 µm und 500 µm oder zwischen 200 µm und 300 µm aufweisen. Die Angaben für die schmalen Kühlpfade zwischen 100 µm und 200 µm geben Bereichsangaben wieder, die je nach Ausführungsform gewählt werden können.

In vorteilhafter Weise kann die Grabenstruktur im Boden des Steuergeräts vorgesehen werden, wobei die Abdichtung zwischen Schaltungsträger und Deckel mit Grabenstruktur sehr leicht zu handhaben ist. Die Abdichtung ist bei planen oder strukturierten Böden und Deckeln auf einfache Weise möglich.

Im Zusammenhang mit der erfindungsgemäßen Ausbildung und Anordnung ist es von Vorteil, dass die Kühlpfade in Gruppen und/oder in verschiedenen voneinander unabhängigen Gruppen in der Oberfläche des Bodens, des Schaltungsträgers und des Deckels eingelassen sind, wobei jeweils die einzelnen Gruppen in Durchflussverbindung stehen.

Vorteilhaft ist es ferner, dass nach Eingabe der Kühlflüssigkeit in die Kühlpfade des Steuergeräts eine bestimmte Menge der Kühlflüssigkeit zur Erzeugung eines Unterdrucks im verschlossenen Steuergerät wieder abgepumpt wird.

Außerdem ist es vorteilhaft, dass der Deckel und/oder der Boden aus elektrisch leitfähigem oder aus elektrisch isoliertem Material bestehen.

Anhand der Zeichnung wird die Erfindung nachstehend eingehender beschrieben.

Es zeigt:
- Figur 1: eine Schnittdarstellung eines Steuergeräts mit zumindest einem Boden und einem diesem zugeordneten Schaltungsträger;
- Figur 2: ein weiteres Ausführungsbeispiel des Steuergeräts, wobei im Deckel flache Gräben eingebracht sind;
- Figur 3: ein weiteres Ausführungsbeispiel des Steuergeräts, wobei im Deckel tiefe und flache Gräben eingebracht sind;
- Figur 4: ein weiteres Ausführungsbeispiel des Steuergeräts, wobei in den Schaltungsträger tiefe und flache Gräben eingebracht sind, die aber nicht abwechseln sondern Gruppen bilden;
- Figur 5: ein weiteres Ausführungsbeispiel des Steuergeräts, wobei in den Schaltungsträger tiefe und in den Deckel flache Gräben eingebracht sind;
- Figur 6: ein weiteres Ausführungsbeispiel des Steuergeräts, wobei in den Schaltungsträger flache und in den Deckel tiefe Gräben eingebracht sind, wobei diese Anordnung auch im Boden vorgesehen werden kann;
- Figur 7: eine Draufsicht gemäß Figur 3, wobei alle Gräben miteinander verbunden sind;
- Figur 8: ein weiteres Ausführungsbeispiel des Steuergeräts in Draufsicht gemäß Figur 3 mit Wärmequellen.

### Ausführungsformen

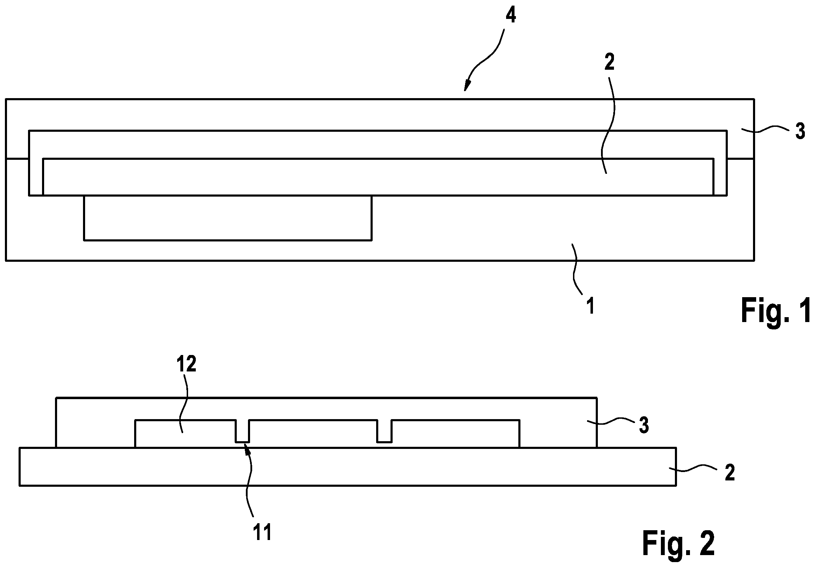

Der Darstellung gemäß Figur 1 ist zu entnehmen, dass ein Steuergerät 4 mit zumindest einem Boden 1 und einem diesem zugeordneten Schaltungsträger 2 sowie einem das Steuergerät 4 verschließenden Deckel 3 ausgestattet ist. Das Steuergerät 4 kann mit Hilfe eines in der Zeichnung nicht dargestellten, die Wärme ableitenden Substrats und/oder von Wärme ableitenden Bauelementen auf eine gewünschte Temperatur gebracht werden. Der Deckel 3 schließt den Boden 1 vakuumdicht ab.

Zur Erzeugung eines Unterdrucks im verschlossenen Steuergerät 4 wird nach Eingabe der Kühlflüssigkeit in Kühlpfade 11 und/oder 12 des Steuergeräts 4 eine bestimmte Menge der Kühlflüssigkeit wieder abgepumpt. Hierdurch wird der Anpressdruck zwischen dem Deckel 3 und dem Boden 1 erhöht.

Auf einem der drei Teile, also Boden 1, Schaltungsträger 2 und Deckel 3, sind auf den jeweils innen liegenden Seiten des entsprechenden Bauteils Vertiefungen bzw. Gräben, nachstehend auch als Kühlpfade 11, 12 bezeichnet, eingebracht, die höchstens eine Tiefe T von 300 µm aufweisen.

Die Kühlpfade 11 können eine Tiefe T kleiner als 200 µm oder kleiner als 120 µm aufweisen oder eine Tiefe zwischen 10 µm und 120 µm insbesondere zwischen 50 µm und 110 µm.

Diese Grabenstrukturen bilden gemeinsam eine oder mehrere Öffnungen in Form von Höhlensystemen bzw. Räumen. Die Gräben werden nach der Ausformung teilweise mit Wasser oder einer anderen Kühlflüssigkeit gefüllt. Die Abdichtung dieser Grabenstruktur erfolgt mit Hilfe eines Gehäuseteils bzw. des Deckels 3. Der Deckel 3 verschließt das Steuergerät 4 vakuumdicht. Da hohe und tiefe Gräben eingebracht werden können, ist die Herstellung der einzelnen Bauteile nicht so aufwändig, da die Toleranzen nicht so genau beachtet werden, müssen wie bei der Herstellung bekannter Steuergeräte.

Gemäß Figur 2 sind in den Deckel 3 tiefe und flache Gräben 11, 12 eingebracht. Diese Anordnung kann in der Ausführungsform gemäß Fig. 1 nicht gewählt werden, da dies durch den Einbau des Schaltungsträgers 2 ausgeschlossen wird. Die Kühlpfade 11 können auch nur im Boden 1 oder nur im Deckel 3 oder nur im Schaltungsträger 2 oder in allen Teilen, also im Deckel 3, Schaltungsträger 2 und Boden 1 vorgesehen werden.

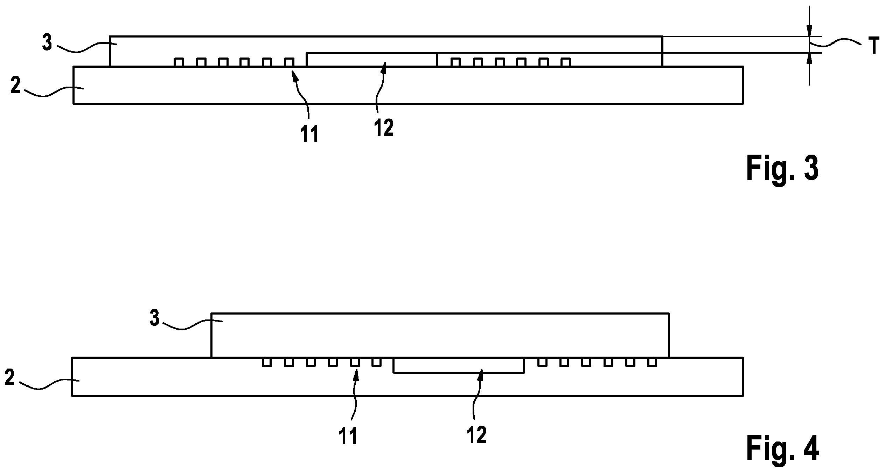

In Figur 3 sind im Deckel 3 tiefe und flache Gräben bzw. Kühlpfade 11, 12 eingebracht, die mit weiteren Kühlpfaden jeweils zu Gruppen 10 zusammengeschlossen und miteinander verbunden sind. Die Gruppen 10 können aber auch nicht miteinander verbunden sein. Diese Anordnung ist deshalb möglich, weil der Schaltungsträger 3 gemäß Fig. 1 weggelassen ist. Die gleiche Anordnung wie im Deckel 3 kann ebenso im Boden 1 vorgesehen werden.

In Figur 4 sind in den Schaltungsträger 2 tiefe und flache Gräben, Kühlpfade bzw. Kühlräume 11, 12 eingebracht, die in der Reihenfolge nicht abwechseln, sondern jeweils in Gruppen 10 zusammengefasst sind. Dieses Steuergerät 4 wird durch den Deckel 3 verschlossen. Anstelle der Anordnung der Kühlpfade 11, 12 im Deckel 3 kann diese, wie zuvor erwähnt, auch im Boden 1 vorgesehen werden.

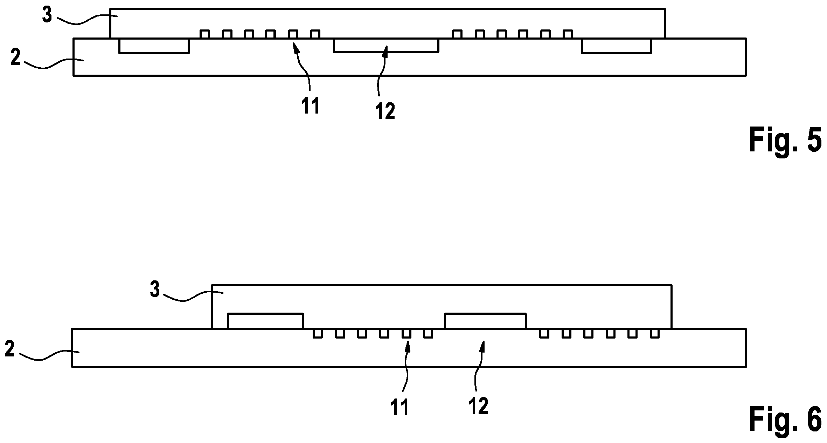

In Figur 5 sind in den Schaltungsträger 2 tiefe breite Gräben bzw. Kühlpfade 12 eingebracht, während im Deckel 3 flache schmale Gräben bzw. Kühlpfade 11 vorgesehen sind.

In Figur 6 sind in den Deckel 3 tiefe breite Gräben bzw. Kühlpfade 12 und in den Schaltungsträger 2 flache schmale Gräben bzw. Kühlpfade 11 eingebracht. Diese Anordnung kann statt im Deckel 3 auch im Boden 1 vorgesehen sein.

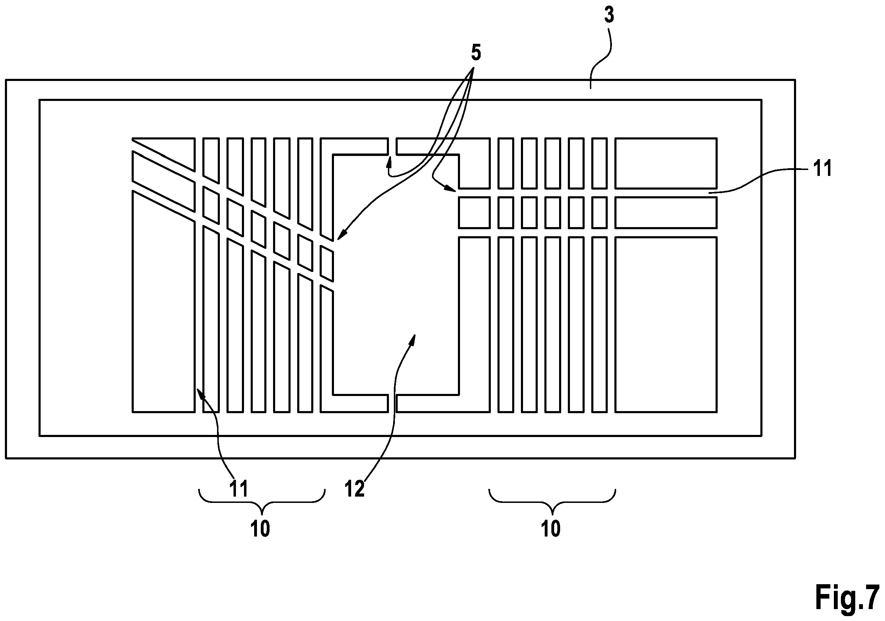

In Figur 7 ist eine Draufsicht von Figur 3 dargestellt, aus der hervorgeht, dass alle Gräben bzw. Kühlpfade 11, 12 miteinander verbunden sind. Die einzelnen Kühlpfade 11 weisen ebenfalls Öffnungen 5 auf, die in die breiten Gräben bzw. Kühlpfade 12 münden. Die Gräben bzw. Kühlpfade 11, 12 sind in der Form eines Höhlensystems ausgebildet.

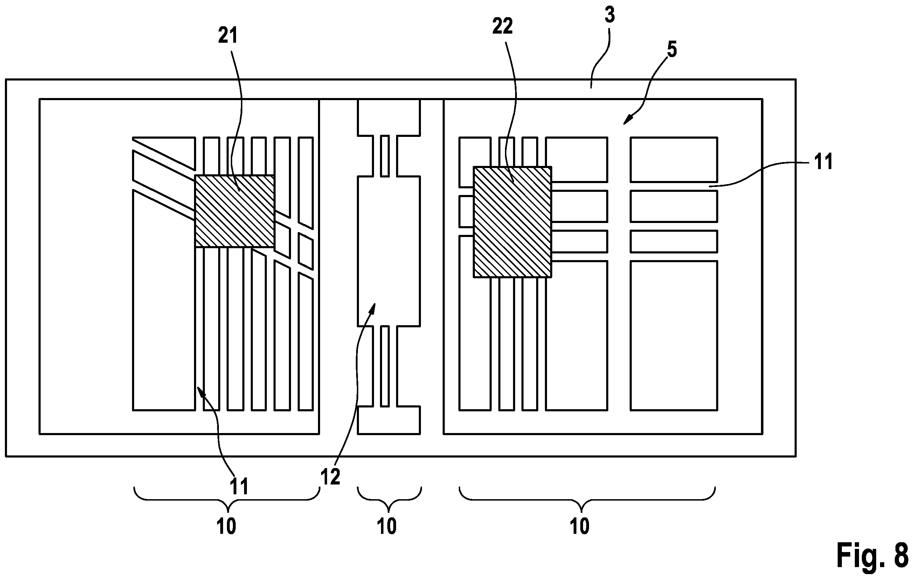

Figur 8 zeigt ein weiteres Ausführungsbeispiel in Draufsicht ähnlich wie in Figur 3. In diesem Ausführungsbeispiel sind Wärmequellen 21 und 22 vorgesehen, die zum Teil die Kühlkanäle 11 abdecken. Diese Wärmequellen können je nach Leistungsbedarf als Bipolartransistioren, IGBT oder MOSFETs bestehen. Ferner können integrierte Schaltungen µC, ASIC oder Treiber-Ics eingesetzt werden. Es können zum Beispiel drei Kühlgruppen 10 gebildet werden, die untereinander verbunden sind.

Nach Einbringen oder Fügen der Gräben, Räume bzw. Kühlpfade 11, 12 in den verschiedenen Bauteilen wird in die Gräben solange eine Kühlflüssigkeit eingegeben bis sie vollständig gefüllt sind. Anschließend wird die Kühlflüssigkeit zum Teil wieder aus den Gräben bzw. Kühlpfaden 11, 12 herausgepumpt bis sich ein bestimmter Unterdruck im Steuergerät 4 eingestellt hat. Danach können die Öffnungen verschlossen werden, und zwar mit Hilfe von Laserschweißgeräten oder durch Umformen beispielsweise durch Stauchbördeln, Pfropfen oder Kleben.

Die Flüssigkeit wird durch die Kapillarwirkung in den kleineren Gräben festgehalten. Durch den im Steuergerät 4 herrschenden Unterdruck bleiben die größeren Gräben weitgehend frei von Flüssigkeit.

Beim Einsatz der elektronischen Schaltung auf dem Schaltungsträger 2 kann die Temperatur aufgrund der Kapillare im Grabensystem stark ansteigen, sodass die Flüssigkeit lokal über ihren Siedepunkt hinaus erhitzt wird und dadurch als Dampf entweicht. Aufgrund der vorteilhaften Ausgestaltung und Anordnung der Kühlpfade 11 kann weitere Flüssigkeit aus den kühleren Bereichen der Gräben nachgezogen werden und durch die Druck- und Temperaturverhältnisse innerhalb der verschiedenen Hohlräume die Flüssigkeit an anderer Stelle im System wieder kondensieren. Dadurch wird eine gleichmäßige Temperierung bzw. Kühlung oder Erwärmung des äußeren Steuergeräteteils erreicht.

Vorteilhaft ist es auch, dass auf der äußeren Seite des Steuergeräts 4 neben Kapillaren des feineren Grabensystems zusätzliche Kühlrippen vorgesehen sind.

Die schmalen Kühlpfade 11 können eine Größe zwischen 5 µm und 200 µm oder zwischen 10 µm und 150 µm oder zwischen 50 µm und 120 µm oder zwischen 80 µm und 120 µm aufweisen.

Die breiten Kühlpfade 12 weisen eine Größe zwischen 100 µm und 10 mm oder zwischen 200 µm und 500 µm oder zwischen 200 µm und 300 µm auf.

Der Schaltungsträger 2 kann eine Leiterplatte aus DCB (direct copper bonded), ein IMS (Isolated metal substrate), ein Stanzgitter (Leadframe), eine LTCC (Low temperature cofired ceramic), eine HTCC (High temperature cofired ceramic) oder eine Kombination der genannten Werkstoffe aufweisen.

Der Boden 1 und/oder der Deckel 3 können aus metallischen, nichtmetallischen oder aus Verbundwerkstoffen bestehen, die im Fertigungsverfahren bzw. im Druckgussverfahren oder in Gesenkschmieden durch Tiefziehen oder Spritzguss oder durch Strangpressen, Extrusion oder Blasformen hergestellt sein können.

Die Gräben bzw. Kühlpfade 11, 12 werden durch Abformen, Ätzen oder Lasern bzw. durch Fräsen hergestellt. Unter Berücksichtigung der Kapillarfähigkeit können diese Kühlpfad-Größen frei gewählt werden. Es muss nur sichergestellt sein, dass der Kondensierungs-Prozess außerhalb der kleineren Gräben stattfinden kann.

Bei gepackten elektronischen Bauelementen oder Bauelementgruppen können die Leadframes bzw. Stanzgitter mit einer oder mehreren Grabenstrukturen versehen sein. Ferner ist es möglich, in der Oberfläche von blanken Chips die erfindungsgemäße Grabenstruktur vorzusehen.

Die erfindungsgemäße Ausgestaltung des Steuergeräts 4 bietet eine gute Möglichkeit einen Patent-Verletzungsfall ohne weiteres nachzuweisen, da hierzu das Bauteil lediglich aufgesägt werden muss, damit die mit Flüssigkeit gefüllten Kanäle sichtbar werden.

## Patentansprüche

1. Steuergerät (4) mit zumindest einem Boden (1) und einem diesem zugeordneten Schaltungsträger (2) sowie einem das Steuergerät (4) verschließenden Deckel (3), wobei das Steuergerät (4) mit Hilfe eines die Wärme ableitenden Substrats und/oder von Wärme ableitenden Bauelementen auf eine gewünschte Temperatur gebracht werden kann, und wobei zumindest innerhalb des Steuergeräts (4) das Substrat von Kühlpfaden (12) aufgenommen ist, **dadurch gekennzeichnet, dass** das Steuergerät breite Kühlpfade (12) und schmale Kühlpfade (11) aufweist, dass die schmalen Kühlpfade (11) in die breiten Kühlpfade (12) münden und dass die Kühlflüssigkeit innerhalb der Kühlpfade (11, 12) zirkulieren kann.

2. Steuergerät nach Anspruch 1, **dadurch gekennzeichnet, dass** die Kühlpfade (11, 12) als Vertiefungen und/oder Gräben ausgebildet und sind.

3. Steuergerät nach Anspruch 1 oder 2, **dadurch gekennzeichnet**, die Kühlpfade 11, (12) als flache Vertiefungen ausgebildet sind.

4. Steuergerät nach einem der vorhergehenden Ansprüche, **dadurch gekennzeichnet, dass** die breiten Kühlpfade (12) in etwa doppelt so breit sind wie die schmalen Kühlpfade (11).

5. Steuergerät nach einem der vorhergehenden Ansprüche, **dadurch gekennzeichnet, dass** die Tiefe der breiten Kühlpfade (12) etwa halb bis doppelt so groß ist wie die der schmalen Kühlpfade (11).

6. Steuergerät nach einem der vorhergehenden Ansprüche, **dadurch gekennzeichnet, dass** die Kühlpfade (11, 12) im Boden (1) und/oder im Schaltungsträger (2) und/oder im Deckel (3) vorgesehen sind.

7. Steuergerät nach einem der vorhergehenden Ansprüche, **dadurch gekennzeichnet, dass** die Kühlpfade (11, 12) eine Tiefe kleiner als 200 µm oder kleiner als 120 µm oder zwischen 10 µm und 120 µm oder zwischen 50 µm und 120 µm, insbesondere zwischen 50 µm und 110 µm aufweisen.

8. Steuergerät nach einem der vorhergehenden Ansprüche, **dadurch gekennzeichnet, dass** die schmalen Kühlpfade (11) eine Größe zwischen 5 µm und 200 µm oder zwischen 10 µm und 150 µm oder zwischen 80 µm und 120 µm aufweisen.

9. Steuergerät nach einem der vorhergehenden Ansprüche, **dadurch gekennzeichnet, dass** die breiten Kühlpfade (12) eine Größe zwischen 100 µm und 10 mm oder zwischen 200 µm und 500 µm oder zwischen 200 µm und 300 µm aufweisen.

10. Steuergerät nach einem der vorhergehenden Ansprüche, **dadurch gekennzeichnet, dass** die Kühlpfade (12) in Gruppen (10) und/oder in verschiedenen von einander unabhängigen Gruppen (10) in der Oberfläche des Bodens (1), des Schaltungsträgers (2) und/oder des Deckels (3) eingelassen sind, wobei jeweils die einzelnen Gruppen in Durchflussverbindung stehen und dass der Deckel (3) und/oder der Boden (1) aus elektrisch leitfähigem oder aus elektrisch isoliertem Material bestehen.

11. Steuergerät nach einem der vorhergehenden Ansprüche, **dadurch gekennzeichnet, dass** nach Eingabe der Kühlflüssigkeit in die Kühlpfade (12) des Steuergeräts (4) eine bestimmte Menge der Kühlflüssigkeit zur Erzeugung eines Unterdrucks im verschlossenen Steuergerät (4) wieder abgepumpt wird.

## Claims

1. Control unit (4) comprising at least one base (1) and a circuit carrier (2) assigned thereto and also a cover (3) that closes the control unit (4), wherein the control unit (4) can be brought to a desired temperature with the aid of a substrate which dissipates the heat and/or components which dissipate heat, and wherein the substrate is accommodated by cooling paths (12), at least inside the control unit (4), **characterized in that** the control unit has wide cooling paths (12) and narrow cooling paths (11), **in that** the narrow cooling paths (11) open out into the wide cooling paths (12) and **in that** the cooling fluid can circulate within the cooling paths (11, 12).

2. Control unit according to Claim 1, **characterized in that** the cooling paths (11, 12) are formed as depressions and/or trenches.

3. Control unit according to Claim 1 or 2, **characterized in that** the cooling paths (11, 12) are formed as shallow depressions.

4. Control unit according to one of the preceding claims, **characterized in that** the wide cooling paths (12) are approximately twice as wide as the narrow cooling paths (11).

5. Control unit according to one of the preceding claims, **characterized in that** the depth of the wide cooling paths (12) is approximately half to twice that of the narrow cooling paths (11).

6. Control unit according to one of the preceding claims, **characterized in that** the cooling paths (11, 12) are provided in the base (1) and/or in the circuit carrier (2) and/or in the cover (3).

7. Control unit according to one of the preceding claims, **characterized in that** the cooling paths (11, 12) have a depth of less than 200 µm or less than 120 µm or between 10 µm and 120 µm or between 50 µm and 120 µm, in particular between 50 µm and 110 µm.

8. Control device according to one of the preceding claims, **characterized in that** the narrow cooling paths (11) have a size of between 5 µm and 200 µm or between 10 µm and 150 µm or between 80 µm and 120 µm.

9. Control unit according to one of the preceding claims, **characterized in that** the wide cooling paths (12) have a size of between 100 µm and 10 mm or between 200 µm and 500 µm or between 200 µm and 300 µm.

10. Control unit according to one of the preceding claims, **characterized in that** the cooling paths (12) are formed in groups (10) and/or in various independent groups (10) in the surface of the base (1), of the circuit carrier (2) and/or of the cover (3), wherein the individual groups are respectively in flow connection and **in that** the cover (3) and/or the base (1) consist(s) of electrically conductive or electrically insulated material.

11. Control unit according to one of the preceding claims, **characterized in that**, after introducing the cooling fluid into the cooling paths (12) of the control unit (4), a certain amount of the cooling fluid is pumped away again to create a negative pressure in the closed control unit (4).

## Revendications

1. Appareil de commande (4) comportant au moins une base (1) et un porte-circuit (2) associé à celui-ci ainsi qu'un capot (3) refermant l'appareil de commande (4), dans lequel l'appareil de commande (4) peut être amené à une température souhaitée au moyen d'un substrat dissipant la chaleur et/ou de composants dissipant la chaleur, et dans lequel le substrat est logé dans des trajets de refroidissement (12) au moins à l'intérieur de l'appareil de commande (4), **caractérisé en ce que** l'appareil de commande présente des trajets de refroidissement (12) larges et des trajets de refroidissement (11) étroits, **en ce que** les trajets de refroidissement (11) étroits débouchent dans les trajets de refroidissement (12) larges et **en ce que** le fluide de refroidissement peut circuler à l'intérieur des trajets de refroidissement (11, 12).

2. Appareil de commande selon la revendication 1, **caractérisé en ce que** les trajets de refroidissement (11, 12) sont réalisés sous la forme d'évidements et/ou de tranchées.

3. Appareil de commande selon la revendication 1 ou 2, **caractérisé en ce que** les trajets de refroidissement (11, 12) sont réalisés sous la forme d'évidements plans.

4. Appareil de commande selon l'une quelconque des revendications précédentes, **caractérisé en ce que** les trajets de refroidissement (12) larges sont approximativement deux fois plus larges que les trajets de refroidissement (11) étroits.

5. Appareil de commande selon l'une quelconque des revendications précédentes, **caractérisé en ce que** la profondeur des trajets de refroidissement (12) larges est approximativement comprise entre la moitié et le double de celle des trajets de refroidissement (11) étroits.

6. Appareil de commande selon l'une quelconque des revendications précédentes, **caractérisé en ce que** les trajets de refroidissement (11, 12) larges sont disposés dans la base (1) et/ou dans le porte-circuit (2) et/ou dans le capot (3).

7. Appareil de commande selon l'une quelconque des revendications précédentes, **caractérisé en ce que** les trajets de refroidissement (11, 12) présentent une profondeur inférieure à 200 µm ou inférieure à 120 µm ou comprise entre 10 µm et 120 µm ou comprise entre 50 µm et 120 µm, notamment entre 50 µm et 110 µm.

8. Appareil de commande selon l'une quelconque des revendications précédentes, **caractérisé en ce que** les trajets de refroidissement (11) étroits présentent une taille comprise entre 5 µm et 200 µm ou entre 10 µm et 150 µm ou entre 80 µm et 120 µm.

9. Appareil de commande selon l'une quelconque des revendications précédentes, **caractérisé en ce que** les trajets de refroidissement (12) étroits présentent une taille comprise entre 100 µm et 10 mm ou entre 200 µm et 500 µm ou entre 200 µm et 300 µm.

10. Appareil de commande selon l'une quelconque des revendications précédentes, **caractérisé en ce que** les trajets de refroidissement (12) sont introduits dans des groupes (10) et/ou dans des groupes (10) différents indépendants les uns des autres dans la surface de la base (1), du porte-circuit (2) et/ou du capot (3), dans lequel les groupes individuels sont respectivement en liaison de communication et **en ce que** le capot (3) et/ou la base (1) est/sont constitué(s) d'un matériau électriquement conducteur ou électriquement isolant.

11. Appareil de commande selon l'une quelconque des revendications précédentes, **caractérisé en ce qu'**une quantité déterminée du fluide de refroidissement, après introduction du fluide de refroidissement dans les trajets de refroidissement (12) de l'appareil de commande (4), est de nouveau prélevé par pompage pour générer une sous-pression dans l'appareil de commande (4) fermé.
